(19) **Europäisches Patentamt**
**European Patent Office**
**Office européen des brevets**

(11) **EP 1 723 682 B1**

(12) **EUROPEAN PATENT SPECIFICATION**

(45) Date of publication and mention
of the grant of the patent:
**31.07.2013 Bulletin 2013/31**

(51) Int Cl.:
*H01L 31/0224* (2006.01)  *H01L 31/032* (2006.01)
*H01L 31/052* (2006.01)

(21) Application number: **05711173.4**

(86) International application number:
**PCT/SE2005/000321**

(22) Date of filing: **03.03.2005**

(87) International publication number:
**WO 2005/088731 (22.09.2005 Gazette 2005/38)**

(54) **THIN FILM SOLAR CELL AND MANUFACTURING METHOD**

DÜNNFILM-SOLARZELLE UND HERSTELLUNGSVERFAHREN

CELLULE SOLAIRE A COUCHE MINCE ET SON PROCEDE DE FABRICATION

(84) Designated Contracting States:
**AT BE BG CH CY CZ DE DK EE ES FI FR GB GR
HU IE IS IT LI LT LU MC NL PL PT RO SE SI SK TR**

(30) Priority: **11.03.2004 SE 0400631**

(43) Date of publication of application:
**22.11.2006 Bulletin 2006/47**

(73) Proprietor: **Solibro Research AB
756 51 Uppsala (SE)**

(72) Inventors:
• **MALMSTRÖM, Jonas
S-752 17 Uppsala (SE)**
• **STOLT, Lars
S-755 91 Uppsala (SE)**

(74) Representative: **Franks, Barry Gerard et al
BRANN AB
P.O. Box 12246
102 26 Stockholm (SE)**

(56) References cited:
WO-A1-03/007386          WO-A1-2004/100250
WO-A2-2004/032189      US-A1- 2004 063 320
US-B1- 6 288 325

• OLLE LUNDBERG: "Band gap profiling and high
speed deposition of Cu(In, Ga)Se2 for thin film
solar cells", 21 November 2003 (2003-11-21),
ACTA UNIVERISITATIS UPSALIENSIS, UPPSALA
SWEDEN
• SEBASTIAN SCHLEUSSNER: "Cu(In,Ga)Se2 thin
film solar cells with ZrN as a back contact,
Diplomarbeit", 2003, UNIVERSITAET
STUTTGART, STUTTGART
• 'Email dated 9.08.2007 from Prof. Dr. Werner to
the European Patent Office'
• 'Final technical report: Production of large-area
CIS-based modules, project N° NNE5-2000-0398,
Contract N° ENK5-CT-2000-00331' 28 February
2004, XP055014151
• ORGASSA K ET AL: "Alternative back contact
materials for thin film Cu(In,Ga)Se2 solar cells",
THIN SOLID FILMS, ELSEVIER-SEQUOIA S.A.
LAUSANNE, CH, vol. 431-432, 1 May 2003
(2003-05-01), pages 387-391, XP004428673, ISSN:
0040-6090, DOI: 10.1016/S0040-6090(03)00257-8

## Description

## Field of the invention

The present invention relates to a thin film solar cell and a method of manufacturing such cells. In particular the invention relates to the use of a back reflector in $Cu(In,Ga)Se_2$ (CIGS) based thin film solar cells with thin absorber layers.

## Background of the invention

Solar cells provide a means to produce electrical power with minimal environmental impact since the solar cells directly convert the energy in the solar radiation into electricity. The solar cell, or photovoltaic (PV), technology has shown an substantial development over the recent year, both with regards to the efficiency of the cells, their reliability, useful life and the cost of production. The solar cell technology is now well established and the global market has shown high growth rates of 20-25% p.a. for more than a decade. However, the high cost of PV electricity is still limiting the accessible market.

The $Cu(In,Ga)Se_2$ (CIGS) thin film solar cell technology is considered one of the most promising candidates for making photovoltaic generation of electricity more cost effective, and thus expanding accessible the market. Compared to the silicon (Si) technology, which dominates today's market, the thin film technology has some inherent advantages in the production process, such as reduced consumption of materials and energy, and simplified electrical interconnections between individual solar cells in a solar cell module. Among the three dominant thin film technologies of today, i.e. CIGS, amorphous silicon (a-Si) and cadmium telluride (CdTe), the CIGS technology has shown the highest power conversion efficiency, now exceeding 19 % [1].

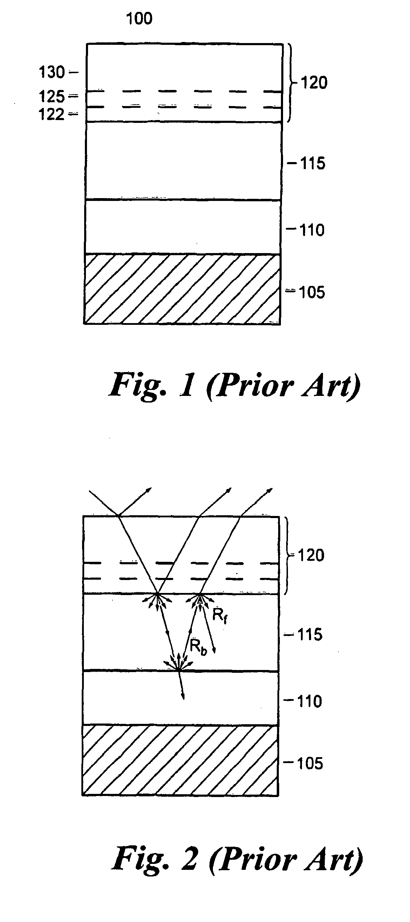

A typical prior art CIGS solar cell 100 is depicted in FIG. 1 and comprises a glass substrate 105 of a thickness of 1-3 mm, an Mo back contact 110 of a thickness of 0.2-1 $\mu$m, a CIGS-layer (absorber) 115 of 1.5-2.5 $\mu$m, a window layer 120 comprising of CdS buffer layer 122 of 40-60 nm, a ZnO layer 125 of 50-100 nm and an ZnO:Al layer 130 of 300-400 nm. The structure may be varied with regards to layer thicknesses and added and/or excluded layers, for example. A number of manufacturing process are used and/or suggested including for example wet processes, sputtering and deposition techniques such as chemical vapor deposition (CVD) and atomic layer deposition (ALD).

Within the CIGS technology, one strategy to further reduce manufacturing costs is to decrease the thickness of the CIGS absorber layer below the 1.5-2.5 $\mu$m that is commonly used today. With a thinner absorber, the consumption of relatively scarce and expensive materials such as Indium (In) and Gallium (Ga) is reduced. Furthermore, at equal deposition rates, a thinner absorber can be grown in shorter time, which translates into increased throughput and, therefore, into reduced capital cost of the production.

A clear disadvantage of too thin absorbers is the reduced performance. As shown by Lundberg and co-workers [2], CIGS solar cells with an absorber thickness below 0.5 $\mu$m can be fabricated with reasonably high efficiency ($\eta$>10%). However, given the standard glass/Mo/CIGS/CdS/ZnO/ZnO:Al structure, illustrated in FIG. 1, there is a clear decrease in efficiency compared to devices with thick ($\sim$1.8 $\mu$m) absorbers. This drop in efficiency is mainly due to a reduced short circuit current of the cell due to reduced absorption in the thinner absorbers [2].

In order to maintain a high optical absorption in a thin absorber, it is known to apply a light trapping scheme. A light trapping scheme can be defined as an arrangement to increase the probability that light that has penetrated into the absorber layer is actually absorbed in this layer. As illustrated in FIG. 2, light trapping can be achieved by making the light travel in the absorber 115 at an oblique angle, e.g. by scattering at the absorber back and front interfaces, and by maximizing the reflectance $R_b$ at the absorber/back contact interface and reflectance $R_f$ at the absorber/window (front) interface. Obviously, to maximize the total absorption of light in the absorber, the coupling of light into the absorber layer should also be maximized by minimizing the reflectance of the window/absorber system as well as the absorption of light in the window.

Light trapping is well established within the a-Si thin film solar cell technology, see e.g. reference [3] and references therein. For CIGS solar cells there has so far been almost no applications of light trapping, primarily due to the fact that the absorption of photons in the solar radiation with an energy exceeding the bandgap energy of the absorber material is almost complete already for CIGS absorbers as thin as 2 $\mu$m. However, as described above, the need for light trapping in CIGS solar cells becomes apparent for cells with sub-micrometer absorber layers. When the CIGS absorber layer is made thinner than the 1.5-2.5$\mu$ m commonly used, a significant fraction of the light that has been transmitted through the window layer to the absorber will not be absorbed during the first pass from the window/absorber interface to the absorber/back contact interface. Since the absorption coefficient of the absorber increases with increasing photon energy, this absorption loss is more pronounced for long photon wavelengths, corresponding to lower photon energies closer to the bandgap energy of the absorber.

Experimental studies on back reflectors for CIGS solar cells, i.e on alternative back contact materials intended to increase the back contact reflectance, includes [4] by the inventors of the present invention, wherein TiN was investigated; and a study by Orgassa and co-workers [5], wherein W, Cr, Ta, Nb, V, Ti, Mn were investigated. In the latter study it was found that while W, Ta, Nb and reference Mo contacts were almost inert, Cr, V, Ti and Mn tended to degrade by chemical reactions with Se. Among the stable W, Ta, and Nb, Nb and above all Ta are expected to have better reflector properties than Mo. An optical effect in measured reflectance of CIGS/back contact samples was visible but to a large extent shadowed by differences in surface scattering. For solar cell devices with 0.9 $\mu$m absorber thickness, differences in the electronic properties of the back contact dominated over the optical difference. Electronic losses at the back contact could be partly suppressed by adding a 0.5 $\mu$m thick sublayer to the CIGS absorber with increasing [Ga]/([Ga]+[In]) ratio (Ga grading) and thereby increasing bandgap towards the back contact. However, with this Ga grading and 1.4 $\mu$m total absorber thickness there was no significant gain in short circuit current with the alternative back contacts.

As for the samples in [4] with TiN back reflector, an optical gain was clearly demonstrated in the quantum efficiency spectrum and in the short circuit current at 0.5 $\mu$m absorber thickness and with Ga grading. However, the optical gain was counteracted by electronic losses, leading to an overall efficiency of 13.1 % compared 13.4 % for the reference device with Mo back contact.

A back contact with good reflector properties seems to be suitable for maintaining a high efficiency of CIGS solar cells with thin (sub-micron) absorber thickness. Such reflector materials are available, but only overall worse or insignificantly improved power conversion efficiency with respect to devices with the standard Mo back contact has been reported.

Further thin film chalcopyrite solar cells with TiN back reflectors are disclosed in O. Lundberg, "Band gap profiling and high speed deposition of Cu(In, Ga)Se2 for thin film solar cells", 21 November 2003, ACTA UNIVERISITATIS UPSALIENSIS, UPPSALA SWEDEN and "Final technical report: Production of large-area CIS-based modules, project N° NNES-2000-0398, Contract N° ENK5-CT-2000-00331", published 28 February 2004, XP55014151.

Summary of the invention

Obviously an improved thin film solar cell structure, and a method of manufacturing such, is needed, which is arranged to minimize or preferably fully compensate for the loss in efficiency of the solar cell structure when reducing the thickness of the absorber. In particular such thin film solar cell need to address the problems of electronic losses associated with the use of reflector layers in prior art solar cell structures.

The object of the invention is to provide a thin film solar cell and a method of manufacturing a thin film solar cell that overcornes the drawbacks of the prior art techniques. This is achieved by the thin film solar cell as defined in claim 1, and the method as defined in claim 24.

The problem is solved by a thin film solar cell which comprises a substrate and an absorber, and a composite back contact provided between the substrate and the absorber. The composite back contact comprises:

- a back reflector layer that enhances the reflectance at the absorber/composite back contact interface;
- a contact layer that ensures suitable electrical properties of the back contact with respect to the absorber; and optionally
- a conductance layer that ensures low sheet resistance for the in-plane current flow. The contact layer preferably modifies the electrical properties of the composite back contact with respect to the contact resistance for majority carriers or the back contact recombination for minority carriers, more preferably the contact layer provides low contact resistance for majority holes and/or low back contact recombination for minority electrons.

The composite back contact afforded by the invention is especially applicable to solar cells with thin film absorbers of the p-type semiconductor Cu(In,Ga)Se$_2$ (CIGS) or Cu(In,Ga)(Se,S)$_2$ or Cu(Al,In)(Se,S)$_2$. The reflector layer is formed by

The method of manufacturing the inventive solar cell structure comprises the steps of:

- formation of a back reflector layer (311) close to the absorber (115);
- optionally formation of a conductance layer on a substrate; and
- formation of an contact layer between the reflector layer (311) and the absorber,

whereby providing a composite back contact (314) between the substrate and the absorber.

One advantage afforded by the present invention is that a reflector layer can be used in the solar cell structure with a thin absorber, without, or at least with very low electronic losses which have been associated with the use of reflector layers in prior art solar cell structures.

A further advantage of the present invention is that the composite back contact can be advantageously combined with arrangements and methods of adding Na to the absorber, for example by the use of a NaF precursor layer.

Yet another advantage of the present invention is that the reflector layer of the composite back contact may protect the other layers of the composite back contact from corrosion and exposure to high temperature and an aggressive chemical environment during the growth of the CIGS absorber. As the composite back contact is entirely made of an inert and stable material (ZrN), the composite back contact as a whole will be highly resistant to corrosion, for example.

Embodiments of the invention are defined in the dependent claims. Other objects, advantages and novel features of the invention will become apparent from the following detailed description of the invention when considered in conjunction with the accompanying drawings and claims.

## Brief description of the figures

The features and advantages of the present invention outlined above are described more fully below in the detailed description in conjunction with the drawings where like reference numerals refer to like elements throughout, in which:

Fig. 1 is a schematic drawing of the layered structure of a prior art CIGS thin film solar cell in the standard case;

Fig 2. schematically illustrates light trapping in the absorber layer by a high reflectance $R_b$ at the absorber/back contact interface and a high reflectance $R_f$ at the absorber/window interface, and by light traveling at an oblique angle in the absorber;

Fig. 3 a) shows a device structure not forming part of the present invention comprising a reflector layer for enhanced back contact reflectance $R_b$, b) shows device structure according to an embodiment of the present invention comprising a contact layer on top of the reflector layer for improved electrical properties of the back contact; c) shows device structure according to an embodiment of the present invention comprising a composite contact layer on top of the reflector layer for improved electrical properties of the back contact.

Fig. 4 shows a simulation of CIGS/back contact reflectance $R_b$ at normal incidence as a function of wavelength for reflector materials Ag, ZrN, and TiN, and for the standard Mo contact;

Fig. 5 a) shows calculated absorption of light in the CIGS absorber layer as a function of the thickness of the absorber for different back contact materials using an ideally specular model (closed symbols) and an ideally scattering model (open symbols), b) shows the absorption gain with ZrN and Mo back reflectors relative $R_b = 0$ in the same model cases;

Fig. 6 is a flowchart illustrating the principle steps of the method according to the present invention;

Fig. 7 shows measured and modeled reflectance of a typical reactively sputtered ZrN reflector;

Fig. 8 shows a comparison of quantum efficiency (QE) spectra of the best cells of the Mo reference samples (dashed lines) and ZrN reflector samples (solid lines) from run A (no contact layer), B (CuGaSe$_2$ contact layer) and C (MoSe$_2$ contact layer);

Fig.9 shows a comparison of internal quantum efficiency IQE($\lambda$)=QE($\lambda$)/(1-R($\lambda$)) and specular device reflectance R ($\lambda$) of the best cells of the Mo reference sample (dashed lines) and ZrN reflector sample (solid lines) from run C, including a MoSe$_2$ contact layer;

## Detailed description of the invention

Embodiments of the invention will now be described with reference to the figures.

In the description a chalcopyrite Cu(In,Ga)Se$_2$ (CIGS, CuIn$_{1-x}$Ga$_x$Se$_2$ with Ga content parameter x in the range 0 to 1) light absorbing layer is used as an preferred example. As appreciated by the skilled in the art other light absorbers may by used in a thin film solar cell according to the invention. Examples of such light absorbers includes, but is not limited to chalcopyrite Cu(In,Ga)(Se,S)$_2$ and chalcopyrite Cu(Al,In)(Se,S)$_2$ in suitable atomic compositions..

From FIG. 2. it can be understood that a high reflectance $R_b$ at the CIGS/back contact 115/110 interface is highly desirable to achieve an efficient light trapping. With a high reflectance for light penetrating through the absorber to the back contact, a high fraction of this light gets another chance to be absorbed when traveling from the back contact towards the front. The commonly used Molybdenum (Mo) back contact 110 is far from optimal from an optical point of view, since it yields a relatively low reflectance at the CIGS/Mo interface 115/110. However, as reported in the above referred studies, to replace the Mo with a material giving a higher reflectance at the CIGS/Mo interface does not necessarily improve the overall efficiency of the solar cell. Specifically, inappropriate electronic properties of the alternative back contact materials have resulted in electronic losses counteracting the optical gain. Thereby, the result may be an overall worse or insignificantly improved power conversion efficiency compared to the devices with the common Mo back contact. Possible factors significantly influencing the efficiency include the properties for the majority carriers (holes) and minority carriers (electrons) in or near the CIGS/back contact interface 115/110, and resistive properties for the solar cell current. In selecting a material suitable with regards to the optical properties also these factors need to be addressed. This narrows the choice of back contact materials. The requirements the back contact needs to meet may be summarized as follows:

■ A high reflectance $R_b$ relative to the absorber layer

■ Have low sheet resistance to carry the solar cell current with small power losses;

■ Be chemically inert to withstand the high temperature and aggressive chemical environment during growth of the CIGS absorber and to be highly resistant to corrosion;

■ Provide low contact resistance for majority carriers (holes) in the CIGS absorber;

■ Result in low recombination at the back contact interface of minority carriers (electrons) in the absorber.

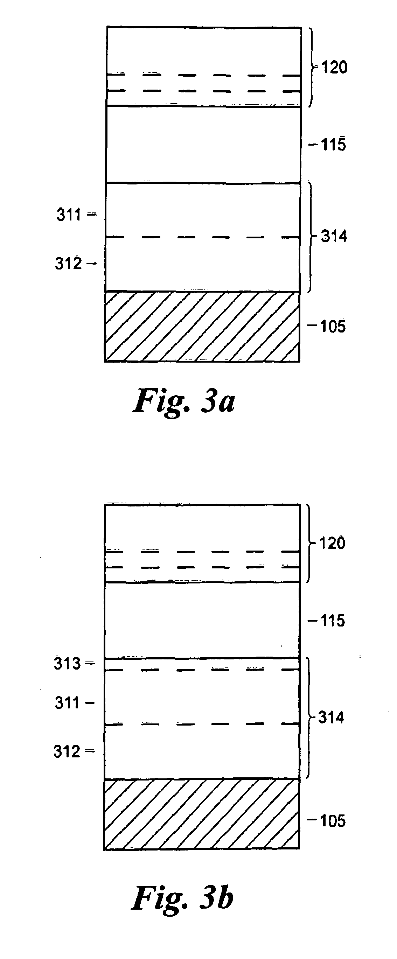

According to the present invention a composite back contact 314 is provided between the glass substrate 105 and the CIGS absorber layer 115, which is illustrated in FIG. 3a-c. By the use of a plurality of layers the composite back contact 314 may provide a combination of properties meeting the above stated requirements, not at least combining a highly reflective back contact with good electronic properties. The composite back contact 314 comprises:

1) A back reflector layer 311 that yields high reflectance at the absorber/back contact interface; and

2) At least one contact layer 310, 313 that ensures suitable electrical properties of the back contact with respect to the absorber, .e.g. makes it possible to fulfill preferably both, but at least one of the demands on low contact resistance for majority carriers and low recombination of minority carriers at the composite back contact 314; and

3) At least one conductance layer 312 that ensures low sheet resistance for the in-plane current flow.

By using a combination of layers the material demands on each of the layers are relieved. This widens the choice of candidate materials and makes it possible to implement a composite back contact 314 that have the possibility to yield higher power conversion efficiency than thin film solar cells with a thin absorber layer and the standard Mo back contact. Hence, the composite back contact compensate at least partly for the reduction in power conversion efficiency previously associated with the reduction of the absorber layer. To provide a contact layer 310, 313 can be seen as matching the electronic properties of the absorber layer 115 to the electronic properties of the reflector layer 311 using an intermediate contact layer 310, 313 with appropriate electronic properties, in order to at least maintain the electrical performance of the device obtained when a reflector layer 311 is not used. In some cases, more than one of the layers described above can be realized by the same material.

According to a device not forming part of the present invention, illustrated in FIG. 3a, a reflector layer 311 with appropriate optical properties and a conductance layer 312, preferably Mo, has been introduced in the solar cell structure 100 below the CIGS absorber 115, to obtain a high value of $R_b$ and a low sheet resistance. The reflector layer 311 and the conductance layer 312 form the composite back contact 314. The value of the back reflectance should preferably be above 0.5, and more preferably above 0.9, in a region of photon energies 0 - 0.2 eV above the optical bandgap of the absorber. Suitable materials for the reflector layer 311 includes, but is not limited to, zirconium nitride (ZrN), hafnium nitride (HfN), titanium nitride (TiN), silver (Ag), gold (Au) and aluminum (Al). ZrN, HfN or TiN are especially preferred due to their chemical stability and good adhesion properties. The properties and the resulting efficiency of these materials will be further discussed below. Since the reflector layer 311 is combined with the conductance layer 312, the sheet resistance of the reflector layer 311 is not critical. In this case the conductance layer 312 (the low sheet resistance layer) typically and preferably carries most of the current flow in the lateral in-plane directions. The sheet resistance is preferably below 2 $\Omega$/square. Mo is preferred as the conductance layer material, but other materials with suitable electrical and chemical properties such as tungsten (W) and tantalum (Ta) could be used.

In an alternative realization not forming part of the invention the composite back contact 314 is realized with a single material. This can yield acceptable performance if the chosen material meets the above requirement to a satisfactory degree, i.e. a part from the high reflectance, has a reasonably high conductivity and is made thick enough so that the resulting sheet resistance of the reflector layer is sufficiently low. This alternative embodiment may be advantageous from a manufacturing perspective. The properties of ZrN meets the above requirements, both optically and electrically. With a ZrN thickness of 1 $\mu$m, a sheet resistance below 0.5 $\Omega$/square can be obtained. In addition, ZrN has high chemical stability, and is the preferred choice in this alternative.

As discussed above the composite back contact 314 should, to obtain high solar cell performance, have good electrical properties in a plurality of aspects. In addition to a low sheet resistance it should provide an interface to the CIGS absorber layer 115 which have electrical properties which matches the photovoltaic processes in the absorber layer, i.e. be characterized by a low contact resistance for majority carriers (holes) passing from the absorber layer 115 to the composite back contact 314 and a low recombination of minority carriers (electrons) at the absorber/back contact interface 115/314. Some of the best reflector materials available for CIGS solar cells do not result in back contacts with sufficiently good electrical properties.

In an embodiment of the present invention, illustrated in FIG. 3b, the desired electronic properties are achieved with no or very low loss in back contact reflectance $R_b$ by introducing a contact layer 313 with appropriate electronic and optical properties on top of the reflector layer 311 The material properties listed below are advantageous for obtaining the desired optical and electronic properties of the contact layer. The contact layer 313 is preferably a thin layer of a semi-conductor material with the same majority charge type as the material in the absorber 115. Optically, the material in the contact layer should preferably be characterized by an optical bandgap at least 0.2 eV wider than the optical bandgap of the absorber material, as well as high values of the real part and low values of the imaginary part of the complex refractive index compared to the real and imaginary part of complex refractive index of the reflector material, respectively, in the relevant photon energy region. The difference in refractive index allows for high reflectance at the interface to the reflector layer 311. That the contact layer 313 is made thin and has a wide optical bandgap ensures low absorbtance in this layer. Electronically, the contact material is preferably characterized by a high doping, which facilitates a low contact resistance to the reflector layer 311. To suppress recombination of minority carriers at the back contact, the electronic properties of the contact layer should preferably result in a potential barrier that prevents minority carriers from reaching the interface to the reflector layer 311. In the case of p-type absorbers, the contact material should thus preferably be characterized by a lower electronic affinity than the absorber material, while in the case of n-type absorbers be it should preferably be characterized by a larger value of the sum of the electronic affinity and the bandgap compared to the absorber material. To further suppress recombination of minority carriers at the back contact, the contact layer 313 should preferably result in a low density of interface defect states at the interface to the absorber layer 115 and at the interface to the reflector layer 311, which results in a low recombination velocity.

The contact layer 313 is preferably made of $MoSe_2$ Other alternative materials are a selenide or sulphide of a metallic element chosen from group IVB, such as Ti, Zr, Hf; group VB, such as V, Nb, Ta; or group VIB, such as Cr, Mo, W; or group VIIB, such as Mn, Re in the periodical system. ZrN is the material for the reflector layer 311.

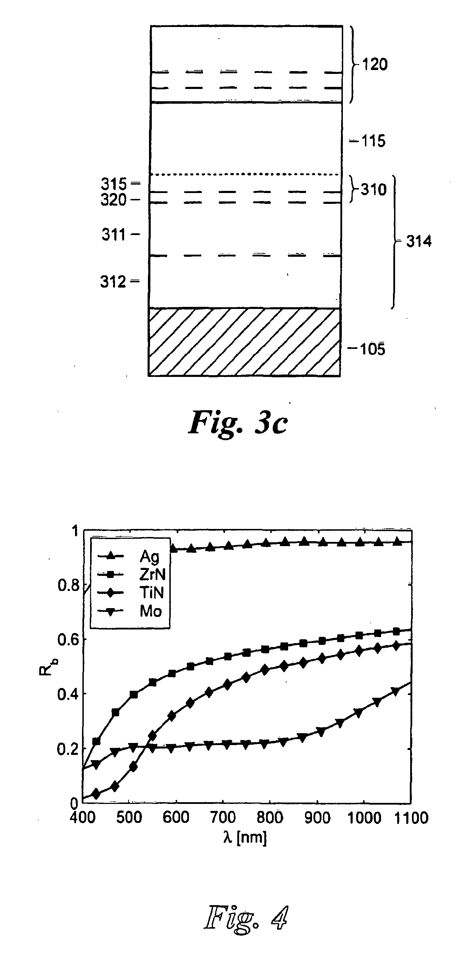

In a second embodiment of the invention the contact layer 313 is realized by a plurality of layers, forming a composite contact layer 310, which is illustrated in FIG 3c. This can further improve the possibilities to fulfill the requirements on the contact layer 313. For example, a first contact layer 320 ensures a low contact resistance for majority carriers and/or low recombination velocity for minority carriers at the interface to the reflector layer 311, and a second contact layer 315 in a composite contact layer can supply a potential barrier that prevents minority carriers from reaching the interface to the reflector layer 311. A preferred composite contact layer in the case of CIGS absorbers is depicted in FIG 3c. A second contact layer 315 (potential barrier layer) of $CuIn_{1-x}Ga_xSe_2$, with x larger than the average x valid for the absorber 115, is provided adjacent to the absorber 115 and thus providing a barrier for minority electrons. The second contact layer 315 is typically and preferably produced in the same manner as, and in a continuous process with, the absorber 115. There will typically not be a sharp distinction between the absorber 115 and the potential barrier layer 315, which is indicated with the dashed line in FIG. 3c. The potential barrier layer 315 will from a different point of view also be part of the absorber 115 in that absorption of light that contributes to the generation of the solar cell current will occur also in the potential barrier layer 315, though to a lesser extent due to the wider bandgap in this layer. A first contact layer 320 of $MoSe_2$, is provided below the potential barrier layer 315. As exemplified in the previous embodiment, other selenides or sulphides can alternatively be used in the first contact layer 320.

In order to fulfill both the optical and electrical requirements the composite back contact 314 should preferably comprise: conductance layer 312, reflector layer 311, and contact layer 313. The layers of the composite back contact having the primarily functions of providing: low sheet resistance for the in-plane current flow; high reflectance at the absorber/back contact interface; and low contact resistance for majority carriers and low back contact recombination for minority carriers, respectively. However, in certain application and/or with careful selection of materials, the conductance layer can be omitted. it is as previously mentioned, for example in many cases possible to use the same material for the reflector layer 311 and the conductance layer 312 as materials providing high reflection often are good conductors. The two layers are then combined into one, but with two different functions in the solar cell structure 100, corresponding to the functions of the conductance layer 312 and the reflector layer 311.

It is generally accepted that the presence of Na in the CIGS layer improves the performance of the absorber. The standard Mo back contact 110 does not act as a diffusion barrier. In this case is the source of Na primarily the glass substrate 105, from which the Na diffuses to the CIGS layer during the manufacturing process. Experiments indicated that layers introduced in the composite back contact 314 according to the present invention may work as a barrier for diffusion of Na from the glass substrate to the CIGS layer. In particular the reflector layer, a ZrN film, can impede the Na diffusion. In this case, Na can be provided to the absorber layer in a controlled manner with known methods, for example by deposition of NaF precursor layers prior to deposition of the absorber layer 115. A method of providing a controlled amount of Na to the absorber by the use of a precursor layer is taught in SE 199400003609.

The back contact may typically be exposed to high temperature and an aggressive chemical environment during the growth of the CIGS absorber, and to corrosion during operation and/or storing of the solar cell. One advantage of the solar cell structure according to the present invention is that the reflector layer can advantageously be used also as a protection of the other layers of the composite back contact 314, or part of the other layers of the composite back contact 314. In order to fulfill this function the reflector layer needs to be chemically inert to withstand the high temperature and aggressive chemical environment during growth of the CIGS absorber and to be highly resistant to corrosion. The reflector material ZrN also exhibits these properties

In the devices wherein ZrN is used both as the reflector material and conductance material the complete composite back contact may be regarded as an inert and stable portion of the cell structure, well suited to withstand the corrosion, for example.

The inert and stable properties of these materials may be advantageously used to fabricate a back contact that is stable during growth of the absorber layer and highly resistant to corrosion also in solar cells structures wherein reflector layers are not needed, e.g. the mentioned standard CIGS solar cells with a absorber (CIGS-layer) of 1.5-2.5 $\mu$m.

The back contact $R_b$ reflectance is determined by the wavelength dependent complex refractive index of the absorber layer and of the back contact material. FIG. 4 shows a simulation of $R_b$ at normal incidence as a function of wavelength for the standard Mo contact, as well as reflector materials TiN, ZrN and Ag. It has been experimentally demonstrated [4] that the higher $R_b$ obtained with TiN than with Mo results in an increased solar cell current. Ag yields the highest $R_b$ but does preferably need further protection in practical devices, since Ag films are not stable by deposition of the CIGS absorber. ZrN shows significantly higher $R_b$ than TiN throughout the spectral region shown in FIG. 4. ZrN is also known to have high chemical stability and has proven stable by evaporation of CIGS absorbers at high temperature. This makes ZrN the choice of back reflector material in the present invention.

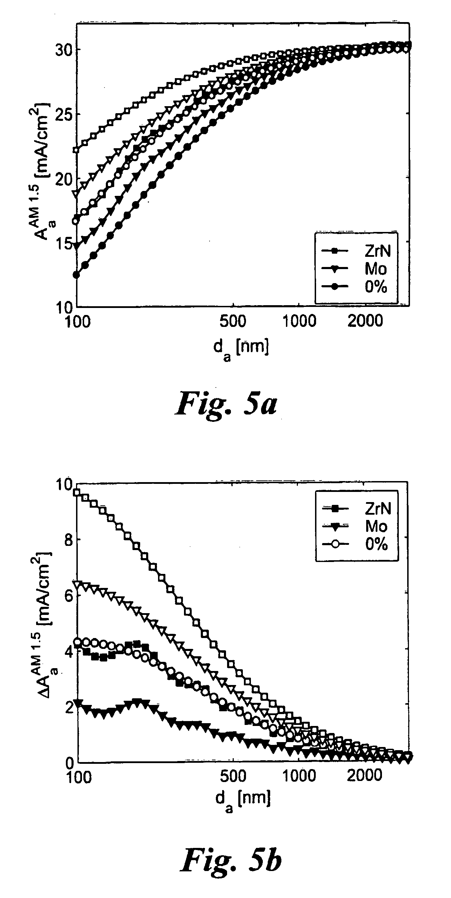

FIG. 5a shows a simulation of the equivalent current density $A_a$ absorbed in the CIGS absorber at normal incidence as a function of the absorber thickness when the incident light is given by the AM 1.5 reference spectrum [6] with ZrN and Mo back reflectors, as well as for the case $R_b = 0$. Closed symbols show results for a specular model with no scattering and complete interference, and open symbols show results for the model case of ideally Lambertian scattering at absorber back and front interfaces, c.f. [4]. FIG. 5b shows the absorption gain with ZrN and Mo back reflectors relative $R_b = 0$ in the same model cases.

The simulation results shown in FIG. 4 and FIG. 5 clearly demonstrate that a gain in absorber absorbance can be obtained with enhanced $R_b$ relative to the standard Mo back contact using a suitable back reflector material such as ZrN. At 500 nm CIGS thickness the gain with ZrN compared to Mo in the specular model is about 1 mA/cm$^2$. The quantitative accuracy of these simulations depends on the quality of the input optical properties and on how well the simplified optical models describe the real case situation.

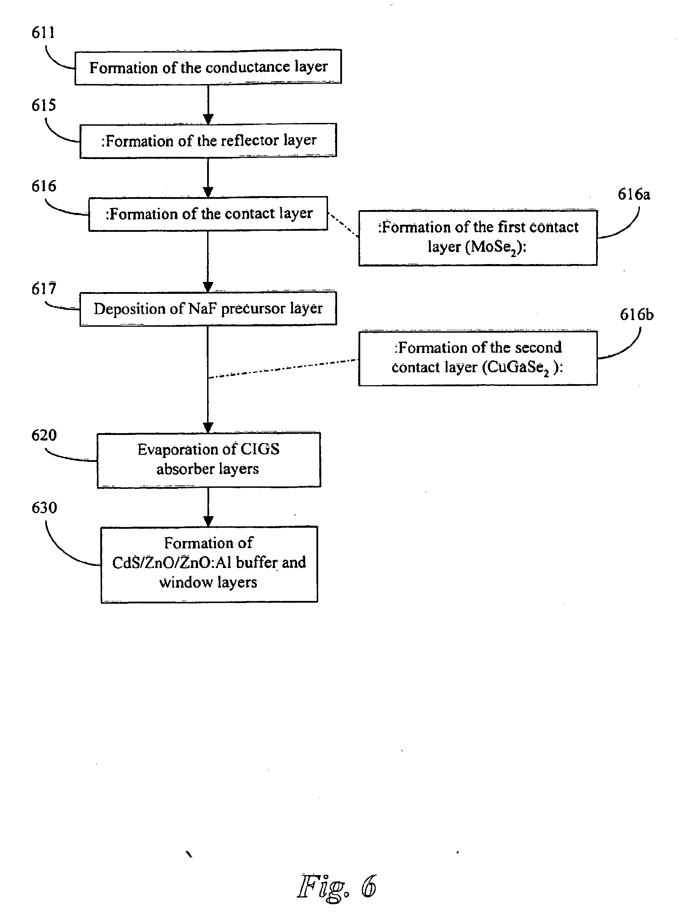

A method according to the present invention of manufacturing solar cell structures according the invention will be described with reference to the flowchart of FIG. 6. The steps of the method that are identical to the known method of producing prior art CIGS solar cells are outlined only briefly and are not to be considered as part of the present invention. A comprehensive description of such prior art methods can be found in for example [7]. The details of each step given below should be considered as non limiting examples. As realized by the skilled in the art, different deposition and evaporation techniques, for example, can be advantageously used depending on the materials used, available equipment etc.

The prior art method, starting from the glass substrate, comprises the steps of:

610: *Sputtering of Mo back contact*

Baseline substrates consist of 1 mm thick soda-lime glass substrates. After cleaning, these substrates are coated with a 0.4 $\mu$m thick layer of molybdenum, deposited by DC magnetron sputtering. The sheet resistance of the Mo back contact is typically 0.5 $\Omega$/sq.

620: *Evaporation of CIGS absorber layers*

The CIGS layer is deposited by co-evaporation from open boat sources of elemental Cu, In, Ga and Se. A quadropole mass-spectrometer is used to control the evaporation rates of Cu, In and Ga. The Se source is temperature controlled and Se is evaporated in excess throughout the evaporation.

630: *Formation of CdS/ZnO/ZnO: Al buffer and window layers*

A 40-50 nm thick CdS buffer layer is deposited by Chemical Bath Deposition (CBD). A second buffer layer of about 80 nm, thick nominally un-doped high-resistive ZnO is deposited by RF magnetron sputtering from a ceramic ZnO target. RF magnetron from an Al-doped ZnO target is used to deposit the transparent conductive ZnO:Al top contact. The thickness of this layer is about 350 nm and the sheet resistance is typically 20-30 $\Omega$/sq.

The method according to the present invention introduces the following steps:

615: *Formation of the reflector layer*

The step is to be performed prior to the step of evaporating the CIGS layer, 620. The reflector layer may be provided in a plurality of ways, but given the nature of the suggested reflector layer materials, sputtering is often a preferred technique. As a way of example a possible process for the zirconium nitride will be given below.

616: *Formation of the contact layer*

The optional step of providing an contact layer on top of the reflector layer may preferably be performed by sputtering, possibly followed by annealing in Se or S atmosphere, or by evaporation, as will be exemplified below. The contact layer may be an composite contact layer formed by a plurality of layers.

617: *Deposition of NaF precursor layer*

The optional step of providing an NaF precursor layer adjacent to the CIGS layer may preferably be performed by evaporation as will be exemplified below.

In the embodiments of the present invention which provides a dedicated conductance layer, the sputtering of Mo back contact layer (step 610) is substituted with the step:

611: *Formation of the conductance layer*

The step is to be performed prior to the step of formation of the reflector layer, 615 and comprises deposition of a layer with low sheet resistance, preferably a layer of molybdenum deposited by DC magnetron sputtering.

**Process examples:**

Examples of realization of the above described steps according to the present invention will be described.

Example of step 615: *Formation of the reflector layer:*

Zirconium nitride (ZrN) back reflector layers were prepared by reactive DC magnetron sputtering from an elemental Zr target in a mixed argon and nitrogen atmosphere on glass or Mo coated glass substrates. The plasma current was kept constant at 2.5 A in all depositions. Several ZrN deposition series were made, in which the sputter parameters process pressure, argon flow and nitrogen flow were varied. Films with good optical properties were obtained for instance with a process pressure of 5 mTorr, 100 sccm Ar flow, 18 sccm $N_2$ flow, and 400 s deposition time. With these settings, a growth rate of about 2.5 nm/s and a resistivity of 0.45 $\mu\Omega$m was obtained on glass substrates, which for a 400 s deposition leads to a sheet resistance below 0.5 $\Omega$/sq. The growth rate was slightly higher, about 3 nm/s, on Mo substrates.

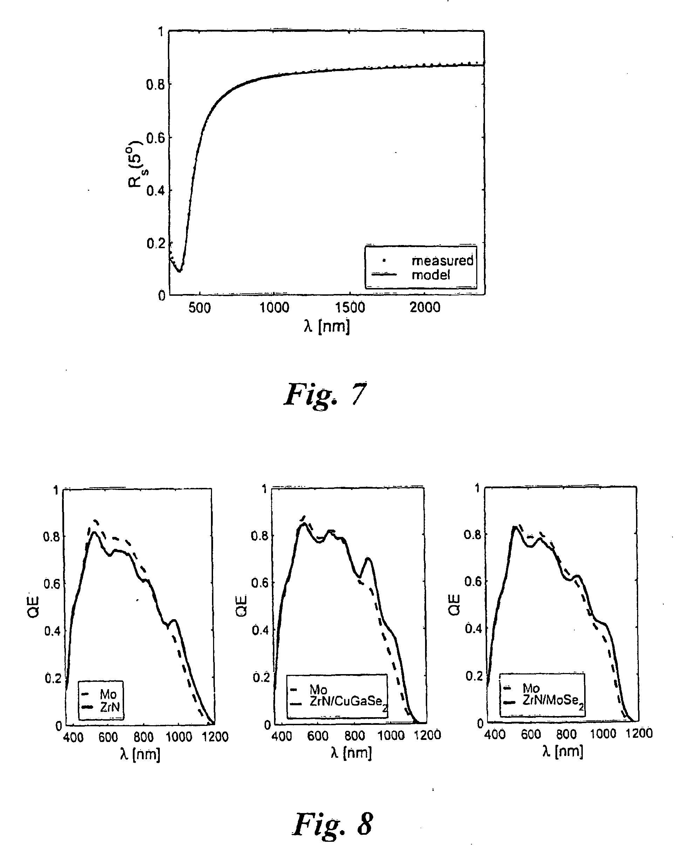

The sputtered ZrN films were optically specular, i.e. non-scattering. The optical properties of a typical ZrN film sputtered on Mo substrate with the process parameters given above are illustrated in FIG. 7 by the specular reflectance measured with s-polarized light at 5° angle of incidence. As also indicated in the figure, the optical properties in the relevant wavelength region 400-1500 nm are well described by the Drude model. According to this model, the dielectric function, which equals the square of the complex refractive index, depends on the photon energy E as

$$\varepsilon(E) = \varepsilon_{\mathrm{inf}} - \frac{E_N^2}{E^2 + i\Gamma E}.$$

Fitting of the parameters in this model to the measured reflectance data shown in FIG. 6 yielded $\varepsilon_{\mathrm{inf}} = 10.28$, $E_N = 9.88$ eV and r = 0.76 eV. The optical properties of ZrN so obtained were used in the simulations shown in FIG. 4 and 5.

*616a: Formation of the contact layer (MoSe$_2$ contact layer):*

On top of some of the ZrN back reflectors, a contact layer of MoSe$_2$ was formed by first sputtering a thin layer of Mo and then exposing this layer at high temperature to a low pressure Se atmosphere. Good results were obtained with a Mo layer thickness of approximately 2 nm. The Se annealing step was carried out in the CIGS evaporation system. The duration was 20 min and the substrates were kept at about 500 °C. Material analysis with X-ray photoelectron spectroscopy (XPS) supported that MoSe$_2$ was formed by this procedure.

*616b: Formation of the contact layer (CuGaSe$_2$ contact layer):*

On top of some of the ZrN back reflectors, a contact layer of CuGaSe$_2$ was formed by co-evaporation, using the CIGS evaporation system. The thickness of this layer was approximately 70 nm. As mentioned above, interdiffusion of Ga and In during growth of the absorber layer will change the composition of this layer and create a gradient in the Ga content. The final composition of the CuGaSe$_2$ contact layer may be $Cu_{1-x}(Ga_xSe_2$ with x <1. In the cases wherein a composite contact layer 310 was used, the MoSe$_2$ contact layer corresponds to the first contact layer 320 and the layer of CuGaSe$_2$ corresponds to the second contact layer 315.

*617: Deposition of NaF precursor layer:*

The NaF was thermally evaporated from a closed boat source in a different evaporation system than was used for CIGS evaporation. The deposition rate and the thickness were monitored by a quartz crystal monitor. For each CIGS preparation, precursors were simultaneously applied to the samples with ZrN back reflectors, with or without a contact layer, and to one reference sample with standard Mo back contact. When chalcopyrite contact layers are used, the NaF precursor can be deposited prior to these layers.

**Comparison of device performance with different solar cell structures**

A number of solar cell fabrication runs were completed by the applicants to evaluate the effect of the composite back contact 314 in a solar cell according to the invention. In each run, a ZrN reflector sample was compared with a Mo reference sample. All process steps were identical except for deposition of ZrN and, if applied, deposition of a MoSe$_2$ or CuGaSe$_2$ contact layer. The device performance was evaluated by current-voltage (IV) measurements and quantum efficiency (QE) measurements. After an initial IV measurement, all devices were annealed in air at 200 °C for a total of four minutes. By this annealing procedure, the efficiency of the solar cell devices was typically enhanced by 1% (absolute).
In the following thee results from three runs are compared, labeled run A, run B and run C. In run A, a reference sample fabricated with a standard Mo back contact is compared with a reflector sample including a ZrN reflector layer in a composite ZrN/Mo back contact, according to the first embodiment of this invention. In run B and C the reference sample is compared with a reflector sample including a contact layer on top of a ZrN reflector, according to the second embodiment of this invention. In run B, the contact layer is of CuGaSe$_2$, and in run C the contact layer is of MoSe$_2$, resulting in composite back contacts MoSe$_2$/ZrN/Mo and CuGaSe$_2$/ZrN/Mo in run B and C, respectively. In run A and C, 8 solar cells with an area of 0.5 cm$^2$ each were defined on each sample, while in run B 16 cells were defined.
The thickness of the CIGS absorber was controlled to around 0.5 -0.6 $\mu$m. The actual thickness was measured by profilometry, and was in each run very similar for reflector and reference samples. The atomic composition of the CIGS layer was measured by X-ray florescence (XRF). For all runs A-C, the ratio [Cu]/([In]+[Ga]) was in the range 0.8-0.9, and the difference in composition between reflector and reference samples was not significant.
FIG. 8 shows a comparison of the quantum efficiency of the best cells of the Mo reference samples and ZrN reflector samples from run A-C. The QE describes the probability that a photon incident on the solar cell contributes to one electron in the measured external current at short circuit conditions as function of the wavelength of the photon. This probability can be viewed as a product of the probability that the incident photon gets absorbed and generates an electron-hole pair in the solar cell, and the average probability that this generated electron-hole pair is collected, i.e. is not prevented from contributing to the photocurrent by recombination in the solar cell.

If the collection probability were the same for reflector samples and reference samples, a higher QE would be expected for the reflector samples, since the increased back contact reflectance $R_b$ (FIG. 4) leads to increased probability for generation of electron-hole pairs in the CIGS absorber. This increased generation is most important for longer wavelengths where the absorption coefficient of CIGS is weaker so that a larger fraction of the light reaches the back contact. If the cells are specular, a higher $R_b$ should also result in a more pronounced interference pattern in the QE in this region. Comparing the QE of reference cells and reflector cells in FIG. 8, it is found that in all runs A-C the reflector cells indeed show higher QE than the references for long wavelengths and that the interference pattern is more pronounced in this region.

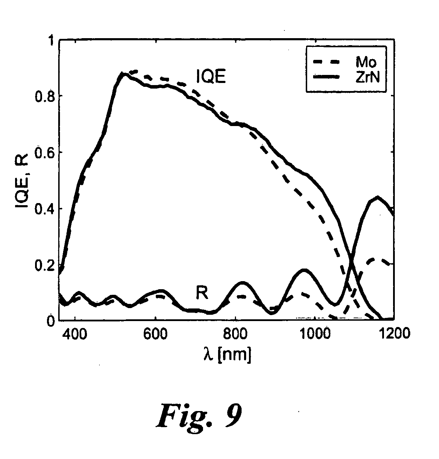

The fact that the QE of the Mo reference cells is higher than the QE of the reflector cells for short wavelengths can be attributed to differences in collection probability. This is supported by measurements of cell reflectance R, which is less sensitive than the QE to $R_b$, but, on the other hand, is insensitive to collection losses. As shown in FIG. 8 for run C, the measured (specular) cell reflectance of the best reflector cell is higher and shows more pronounced interference than the (specular) cell reflectance of the best reference cell, throughout the wavelength region where the cell is active. This clearly shows the beneficial optical effect of the ZrN back reflector, also in the presence of a $MoSe_2$ contact layer. Also shown in FIG. 9 is the internal quantum efficiency $IQE(\lambda)=QE(\lambda)/(1-R(\lambda))$. The increase due to enhanced $R_b$ is larger than in the QE for long wavelengths, and the decrease relative to the reference for shorter wavelengths is smaller.

Table 1 shows average solar cell parameters open circuit voltage $(V_{oc})$, fill factor $(FF)$, short circuit current $(J_{sc})$ and power conversion efficiency ($\eta$) of reference and reflector samples in run A, B and C. The average is taken over values obtained for the cells on each sample, with statistical outliers removed. It is clear from Table 1 that in run A the performance of the reflector sample is significantly worse than the reference, while in run B the performance of the reflector sample is closer to and in run C superior to the reference sample. These differences between run A, B and C can be explained by the improved electrical properties of the back contact when a contact layer is included. In run A, without contact layer on the reflector sample, higher recombination of electrons and higher resistance for holes at the back contact results in decreased performance compared to the reference. In run C, the improved electrical properties of the back contact of the reflector sample when the $MoSe_2$ contact layer is included in combination with the improved optical performance leads to an overall better performance. As appreciated by skilled in art, further improvement can be anticipated when the beneficial effects of the $CuGaSe_2$ contact layer used in run B and the $MoSe_2$ contact layer used in run C are combined in a composite $CuGaSe_2/MoSe_2$ contact layer.

*Table 1: Average solar cell parameters open circuit voltage ($V_{oc}$), fill factor (FF), short circuit current ($J_{sc}$) and power conversion efficiency ($\eta$) of the cells of Mo reference devices and ZrN reflector devices from run A-C. $V_{oc}$ and FF are obtained directly from IV characteristics, while $J_{sc}$ values and consequently, $\eta$ values corrected are corrected for spectral mismatch in the IV measurement using the QE spectra and taking grid losses into account.*

| Run: | A | A | B | B | C | C |
|---|---|---|---|---|---|---|
| Back contact: | Mo | ZrN/Mo | Mo | $CuGaSe_2/ZrN/Mo$ | Mo | $MoSe_2/ZrN/Mo$ |
| $V_{oc}$ [mV] | 535 | 456 | 637 | 572 | 518 | 580 |
| FF [%] | 72.5 | 62.8 | 70.9 | 66.0 | 69.8 | 70.5 |
| $J_{sc}$ [mA/cm$^2$] | 25.0 | 24.9 | 25.3 | 26.9 | 25.5 | 25.4 |
| $\eta$ [%] | 9.7 | 7.2 | 11.4 | 10.2 | 9.2 | 10.4 |

**References**

1. Ramanathan, K., et al., Properties of 19.2% efficiency ZnO/CdS/CuInGaSe2 thin-film solar cells. Progress in Photovoltaics: Research and Applications, 2003. 11(4): p. 225-230.

2. Lundberg, O., Bodegard, M., Malmstrom, J., and Stolt, L., Influence of the Cu(In,Ga)Se2 thickness and Ga grading on solar cell performance. Progress in Photovoltaics: Research and Applications, 2003. 11(2): p. 77-88.

3. Hegedus, S.S. and Kaplan, R., Analysis of Quantum Efficiency and Optical Enhancement in Amorphous Si p-i-n Solar Cells. Progress in Photovoltaics: Research and Applications, 2002. 10(4): p. 257-69.

4. Malmstrom, J., Lundberg, O., and Stolt, L. Potential for light trapping in Cu(In, Ga)Se2 solar cells. in WCPEC-3.

2003. Osaka, Japan.

5. Orgassa, K., Schock, H.W., and Werner, J.H., Alternative back contact materials for thin film Cu(In,Ga)Se2 solar cells. Thin Solid Films, 2003. 431-432: p. 387-391.

6. IEC 60904-3. Photovoltaic devices - Part 3: Measurement principles for terrestrial photovoltaic (PV) solar devices with reference spectral irradiance data. 1 ed. 1989, Geneva: International Electrotechnical Commission.

7. Kessler, J., Bodegard, M., Hedström, J., and Stolt, L., Baseline Cu(InGa)Se2 device production: Control and statistical significance. Solar Energy Materials and Solar Cells, 2001. 67: p. 67-76.

**Claims**

**1.** A thin film solar cell comprising a substrate (105) and a chalcopyrite absorber (115), wherein a composite back contact (314) is provided between the substrate (105 and the chalcopyrite absorber (115), **characterized in that** said composite back contact (314) comprises: a back reflector layer (311) formed of ZrN and, a contact layer (313, 320) that is provided between the back reflector layer (311) and the absorber (115), which contact layer is formed of a selenide or sulphide of a metallic element chosen from periodical system group IVB, or periodical system group VB, or periodical system group VIB, or periodical system group VIIB.

**2.** Thin film solar cell according to claim 1, wherein the composite back contact (314) further comprises a conductance layer (312) formed of Mo and provided between the reflector layer (311) and the substrate (105).

**3.** Thin film solar cell according to claim 1 or 2, **wherein** the chalcopyrite absorber (115) is a thin film of the p-type semiconductor $Cu(In,Ga)Se_2$ (CIGS) or $Cu(In,Ga)(Se,S)_2$ or $Cu(Al,In)(Se,S)_2$.

**4.** Method of manufacturing a thin film solar cell, the method comprises steps of providing a substrate (105) and a chalcopyrite absorber (115), the method **characterized by** providing a composite back contact (314) between the substrate and the chalcopyrite absorber by performing the steps of:

-(615) formation of a back reflector layer (311) between the substrate and the chalcopyrite absorber, which back reflector layer is formed of ZrN, and formation of a contact layer (313, 320) between the back reflector layer (311) and the absorber (115), which contact layer is formed of a selenide or sulphide of a metallic element chosen from periodical system group IVB, or periodical system group VB, or periodical system group VIB, or periodical system group VIIB.

**5.** Method according to claim 4 **further comprising** the step (611) of formation of a conductance layer (312) on the substrate (105).

**Patentansprüche**

**1.** Eine Dünnfilm-Solarzelle, umfassend ein Substrat (105) und einen Chalcopyrit-Absorber (115), wobei ein rückseitiger Verbundkontakt (314) zwischen dem Substrat (105) und dem Chalcopyrit-Absorber (115) bereitgestellt ist, **dadurch gekennzeichnet, dass** der rückseitige Verbundkontakt (314) umfasst: eine aus ZrN gebildete rückseitige Reflektorschicht (311) und eine Kontaktschicht (313, 320), die zwischen der rückseitigen Reflektorschicht (311) und dem Absorber (115) bereitgestellt ist, wobei die Kontaktschicht aus einem Selenid oder Sulfid eines metallischen Elements, ausgewählt aus Gruppe IVB des Periodensystems oder Gruppe VB des Periodensystems oder Gruppe VIB des Periodensystems oder Gruppe VIIB des Periodensystems, gebildet ist.

**2.** Dünnfilm-Solarzelle nach Anspruch 1, wobei der rückseitige Verbundkontakt (314) weiter eine leitfähige Schicht (312) umfasst, die aus Mo gebildet ist und zwischen der Reflektorschicht (311) und dem Substrat (105) bereitgestellt ist.

**3.** Dünnfilm-Solarzelle nach Anspruch 1 oder 2, wobei der Chalcopyrit-Absorber (115) ein Dünnfilm des p-Typ-Halbleiters $Cu(In,Ga)Se_2$ (CIGS) oder $Cu(In,Ga)(Se,S)_2$ oder $Cu(Al,In)(Se,S)_2$ ist.

**4.** Verfahren zur Herstellung einer Dünnfilm-Solarzelle, wobei das Verfahren die Schritte des Bereitstellens eines Substrats (105) und eines Chalcopyrit-Absorbers (115) umfasst, wobei das Verfahren **gekennzeichnet ist durch** Bereitstellen eines rückseitigen Verbundkontakts (314) zwischen dem Substrat und dem Chalcopyrit-Absorber **durch** Durchführen der Schritte:

- (615) Bilden einer rückseitigen Reflektorschicht (311) zwischen dem Substrat und dem Chalcopyrit-Absorber, wobei die rückseitige Reflektorschicht aus ZrN gebildet ist,
und Bilden einer Kontaktschicht (313, 320) zwischen der rückseitigen Reflektorschicht (311) und dem Absorber (115), wobei die Kontaktschicht aus einem Selenid oder Sulfid eines metallischen Elements, ausgewählt aus Gruppe IVB des Periodensystems oder Gruppe VB des Periodensystems oder Gruppe VIB des Periodensystems oder Gruppe VIIB des Periodensystems, gebildet ist.

**5.** Verfahren nach Anspruch 4, weiter umfassend den Schritt (611) des Bildens einer leitfähigen Schicht (312) auf dem Substrat (105).

## Revendications

**1.** Cellule solaire à couche mince comprenant un substrat (105) et un absorbeur en chalcopyrite (115), dans laquelle un contact arrière en composite (314) est disposé entre le substrat (105) et l'absorbeur en chalcopyrite (115), **caractérisée en ce que** ledit contact arrière en composite (314) comprend : une couche de réflecteur arrière (311) formée de ZrN et,
une couche de contact (313, 320) qui est disposée entre la couche de réflecteur arrière (311) et l'absorbeur (115), laquelle couche de contact est formée d'un séléniure ou sulfure d'un élément métallique choisi parmi le groupe IVB du système périodique, ou le groupe VB du système périodique, ou le groupe VIB du système périodique ou le groupe VIIB du système périodique.

**2.** Cellule solaire à couche mince selon la revendication 1, dans laquelle le contact arrière en composite (314) comprend en outre une couche de conductance (312) formée de Mo et disposée entre la couche de réflecteur (311) et le substrat (105).

**3.** Cellule solaire à couche mince selon la revendication 1 ou 2, dans laquelle l'absorbeur en chalcopyrite (115) est une couche mince du semiconducteur de type p $Cu(In,Ga)Se_2$ (CIGS) ou $Cu(In,Ga)(Se,S)_2$ ou $Cu(Al, In) (Se,S)_2$.

**4.** Procédé de fabrication d'une cellule solaire à couche mince, le procédé comprenant les étapes de fourniture d'un substrat (105) et d'un absorbeur en chalcopyrite (115), le procédé étant caractérisé en par la fourniture d'un contact arrière en composite (314) entre le substrat et l'absorbeur en chalcopyrite en réalisant les étapes de :

- (615) formation d'une couche de réflecteur arrière (311) entre le substrat et l'absorbeur en chalcopyrite, laquelle couche de réflecteur arrière est formée de ZrN,
et formation d'une couche de contact (313, 320) entre la couche de réflecteur arrière (311) et l'absorbeur (115), laquelle couche de contact est formée d'un séléniure ou sulfure d'un élément métallique choisi parmi le groupe IVB du système périodique, ou le groupe VB du système périodique, ou le groupe VIB du système périodique ou le groupe VIIB du système périodique.

**5.** Procédé selon la revendication 4, comprenant en outre l'étape (611) de formation d'une couche de conductance (312) sur le substrat (105).

100

130 —
125 =
122 =

120

— 115

— 110

— 105

**Fig. 1 (Prior Art)**

120

$R_f$

$R_b$

— 115

— 110

— 105

**Fig. 2 (Prior Art)**

**Fig. 3a**

**Fig. 3b**

**Fig. 3c**

**Fig. 4**

*Fig. 5a*

*Fig. 5b*

611 — Formation of the conductance layer

615 — :Formation of the reflector layer

616 — :Formation of the contact layer ┈┈ :Formation of the first contact layer (MoSe$_2$): — 616a

617 — Deposition of NaF precursor layer

:Formation of the second contact layer (CuGaSe$_2$): — 616b

620 — Evaporation of CIGS absorber layers

630 — Formation of CdS/ZnO/ZnO:Al buffer and window layers

Fig. 6

**Fig. 7**

**Fig. 8**

*Fig. 9*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- SE 199400003609

### Non-patent literature cited in the description

- **O. LUNDBERG.** Band gap profiling and high speed deposition of Cu(In, Ga)Se2 for thin film solar cells. *ACTA UNIVERISITATIS UPSALIENSIS,* 21 November 2003
- *Final technical report: Production of large-area CIS-based modules, project N° NNES-2000-0398, Contract N° ENK5-CT-2000-00331,* 28 February 2004
- **RAMANATHAN, K. et al.** Properties of 19.2% efficiency ZnO/CdS/CuInGaSe2 thin-film solar cells. *Progress in Photovoltaics: Research and Applications,* 2003, vol. 11 (4), 225-230
- **LUNDBERG, O. ; BODEGARD, M. ; MALMSTROM, J. ; STOLT, L.** Influence of the Cu(In,Ga)Se2 thickness and Ga grading on solar cell performance. *Progress in Photovoltaics: Research and Applications,* 2003, vol. 11 (2), 77-88
- **HEGEDUS, S.S. ; KAPLAN, R.** Analysis of Quantum Efficiency and Optical Enhancement in Amorphous Si p-i-n Solar Cells. *Progress in Photovoltaics: Research and Applications,* 2002, vol. 10 (4), 257-69
- **MALMSTROM, J. ; LUNDBERG, O. ; STOLT, L.** Potential for light trapping in Cu(In, Ga)Se2 solar cells. *WCPEC-3,* 2003
- **ORGASSA, K. ; SCHOCK, H.W. ; WERNER, J.H.** Alternative back contact materials for thin film Cu(In,Ga)Se2 solar cells. *Thin Solid Films,* 2003, vol. 431-432, 387-391
- IEC 60904-3. Photovoltaic devices - Part 3: Measurement principles for terrestrial photovoltaic (PV) solar devices with reference spectral irradiance data. International Electrotechnical Commission, 1989
- **KESSLER, J. ; BODEGARD, M. ; HEDSTRÖM, J. ; STOLT, L.** Baseline Cu(InGa)Se2 device production: Control and statistical significance. *Solar Energy Materials and Solar Cells,* 2001, vol. 67, 67-76